# EUROPEAN PATENT APPLICATION

(11) **EP 4 614 811 A1**
(43) Date of publication of application: **10.09.2025**
(21) Application number: 24161791.9
(22) Date of filing: 06.03.2024
(51) Int. Cl.: H03F 3/195, H03F 3/21, H03F 3/213, H03F 3/217, H03F 3/60, H03F 1/34

(54) **MULTI MODULE RF/MW AMPLIFIER ARCHITECTURE WITH POWER COMBINER FEEDBACK**

(71) Applicant: SolidWatts SA, 1009 Pully (CH)
(72) Inventor: KOVERMANN, Jan W., 01550 Collonges (FR)
(74) Representative: Weihs, Bruno Konrad

(57) **Abstract**

A solid-state power amplifier architecture comprises a plurality of switched mode with gate driver circuit and digital input power amplifier modules, and a digital control circuit configured to drive the plurality of switched mode with digital input power amplifier modules with corresponding digital signals, whereby the digital control circuit is further configured for adjusting the phase of the digital signals relative to each other. The solid-state power amplifier architecture further comprises an RF or MW power combiner with load terminations that are equipped each with a corresponding directional coupler that is configured to sample the signal into the load terminations, and a feedback system implemented in the digital control circuit that uses the sample signals to adjust the phase of the digital signals to each other according to a method that maximises the efficiency of the power combination by minimising the signal into the load terminations by adjusting the phase of the digital signals into the power amplifier modules relative to each other.

## Description

### Technical field of the invention

The invention is in the field of solid-state Radio-Frequency (RF) power amplifiers.

### State of the art

Solid-state RF power amplifiers have seen great steps of improvement in the last years due to the development of high power and high frequency transistors. These transistors now allow the implementation of switch mode amplifier classes, e.g., classes D, E, F, their inverse or mixtures of those.

An implementation of a class E topology with output powers above 100W is described in the document AR211103, ART150PEG, to Ampleon, dated 2.04.2021, and downloadable at: https://www.ampleon.com/documents/application-report/AR211103.pdf.

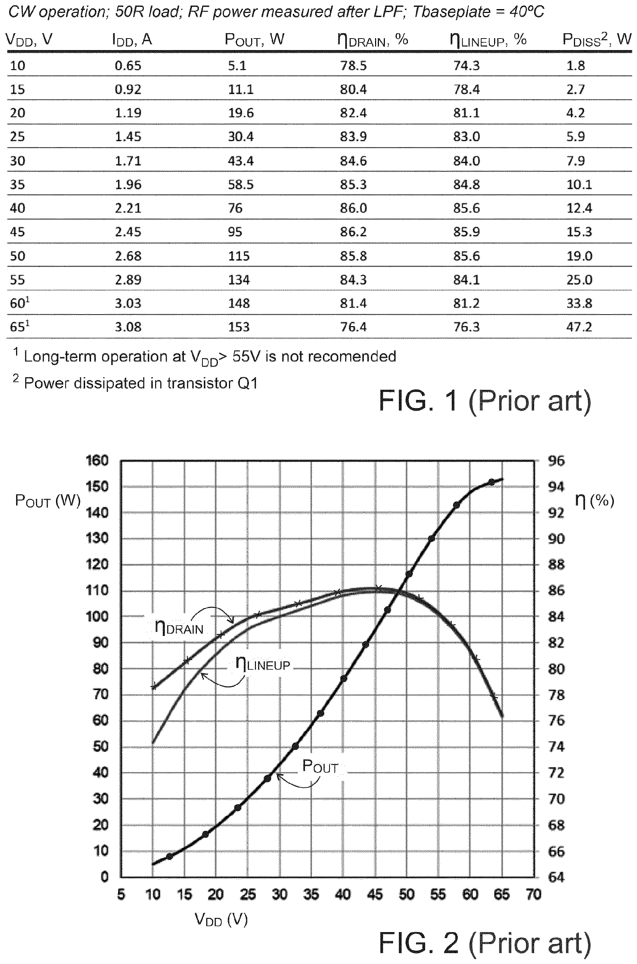

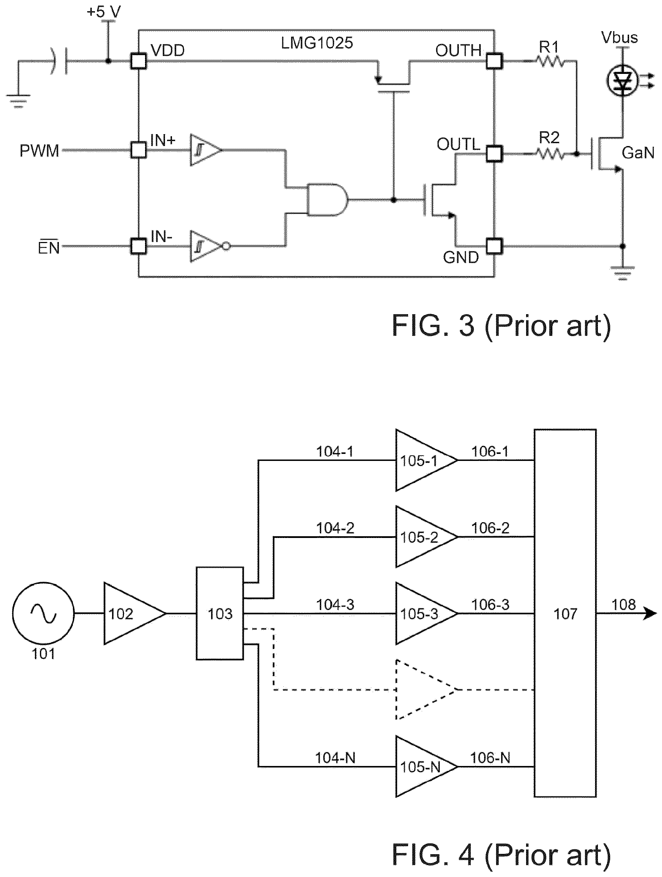

This document presents the measurement results of a class E generator design for the 40MHz band using an ART150PEG power transistor. It provides information on the general description, theory of operation, design recommendations, electrical characteristics, thermal characteristics, and hardware. The document includes figures and tables that illustrate the demo front view, schematic, output power and efficiency, component mapping, bill of materials, and board specifications. The output power of the class E generator is for example discussed in Table 1 and figure 3 of the document, page 5, which are included here as **Figure 1** and **Figure 2****.**

Common to these operating classes is a quasi-digital drive of the input gate of the transistor using gate driver stages (gate driver circuits) typically realised as integrated circuits. An example of such an integrated circuit is shown in the document LMG1023-Q1 Automotive Low Side GaN and MOSFET Driver For High Frequency and Narrow Pulse Application, Texas Instruments, SNOSD74B, May 2019, Revised January 2020, and downloadable at:

### https://www.ti.com/lit/gpn/LMG1025-Q1.

A typical implementation of the gate driver circuit is for example shown in figure 6 of that document, page 10, which is included here as **Figure 3****.**

These gate driver circuits typically accept digital low power signals (e.g., TTL standard) as gate switching control signals. Such signals can be produced using a multitude of different sources, e.g. oscillators, microcontrollers or FPGAs.

For achieving higher RF powers than a single transistor can achieve on its own, the output power of multiple transistors can be combined in a single output using RF power combiners. Several architectures are possible, e.g., the Gysel topology, but all have in common that the RF power coming from the transistors has to be aligned in phase and amplitude. This is often requiring extensive tuning that has a non-negligible cost impact to the final system.

Current state of the art transistors for solid-state high-power radiofrequency (RF) and microwave (MW) amplifiers can reach continuous wave (CW) output power levels in the 2kW range in the RF frequencies, e.g., below 500MHz. If higher power levels are needed for the application, the power of multiple transistors (embedded in Power Amplifier Modules, i.e., PAMs) has to be combined into a single output using a power combiner. In addition - as PAMs are amplifiers - a drive signal has to be created and its power has to be split into the number of PAMs. For efficient power generation, the power splitting, amplification and combination has to be done such that the phases of all parallel PAMs that are driven and combined are the same. Due to component and production tolerances, this task usually needs manual tuning of all involved circuits individually which is a costly and time-consuming process.

Novel switch mode power amplifiers, e.g., classes E and F and similar, allow for the usage of specific integrated circuits (ICs) that directly drive the SSPAs power transistor, so called integrated gate driver ICs. Using these, the drive signal is reduced to a low power digital signal that is more easily created compared to the relatively high-power RF or MW signal that is usually used for this task.

The invention aims to provide an alternative power amplifier architecture.

### Summary of Invention

The invention provides a solid-state power amplifier architecture comprising a plurality of switched mode with gate driver circuit and digital input power amplifier modules, and a digital control circuit configured to drive the plurality of switched mode with digital input power amplifier modules with corresponding digital signals, whereby the digital control circuit is further configured for adjusting the phase of the digital signals relative to each other. The solid-state power amplifier architecture further comprises an RF or MW power combiner with load terminations that are equipped each with a corresponding directional coupler that is configured to sample the signal into the load terminations, and a feedback system implemented in the digital control circuit that uses the sample signals to adjust the phase of the digital signals to each other according to a method that maximises the efficiency of the power combination by minimising the signal into the load terminations by adjusting the phase of the digital signals into the power amplifier modules relative to each other.

In a preferred embodiment, the digital control circuit is implemented in discrete logic, using any one of a microcontroller or an FPGA.

In a further preferred embodiment, the digital signals are transmitted from the source to the power amplifier modules by means of a galvanically decoupled link.

In a further preferred embodiment, the galvanic decoupled link comprises optical fibres.

In a further preferred embodiment, the galvanic decoupled link comprises a transformer.

In a further preferred embodiment, the digital signals for the PAMs can be independently changed in phase using the digital control circuit.

In a further preferred embodiment, the power combiner is an N-channel power combiner that integrates feedback information on an input phase and amplitude alignment and is configured to feed the feedback information to a controller that sets the input phase to the PAMs to achieve best power combination efficiency.

In a further preferred embodiment, the digital control logic is configured to perform self-tests and calibration of the solid-state power amplifier architecture by means of a testing program.

In a further preferred embodiment, the digital control logic is configured to detect failures in the solid-state power amplifier architecture by means of a diagnostics program.

In a further preferred embodiment, the digital signal is a low power signal with only two defined states.

### Brief description of the figures

The invention will be better understood through the detailed description of preferred embodiments of the invention, and in reference to the drawings, wherein:
Fig.1 contains a table with output power and efficiency of a class E generator as a function of drain voltage according to prior art;
Fig. 2 is a graph of output power and efficiency of the class E generator as a function of drain voltage according to prior art;
Fig. 3 is an example of a typical implementation for a gate driver circuit according to prior art;
Fig. 4 shows a RF/MW power amplifier with multiple amplifying elements architecture according to prior art;
Fig. 5 shows a RF/MW power amplifier with multiple amplifying elements architecture according to an example embodiment of the invention;
Fig. 6 shows an example implementation of the digital signals that can be used to drive multiple PAMs according to an example embodiment of the invention;
Fig. 7 shows an overview of a power combiner according to an example of prior art;
Fig. 8 illustrates the digital control circuit from Fig. 5 in more detail, according to an example embodiment of the invention; and
Fig. 9 illustrates an example embodiment of a main control logic from Fig. 8 according to the invention.

Same references will be used to reference the same or similar feature throughout the Figures.

### Detailed description of preferred embodiments of the invention

A power amplifier topology is described that uses low power digital signals (e.g. TTL, LVTTL or any other signal that transmits two logic states based on two defined voltage or current levels) to drive multiple PAMs whose power is then combined into a single output using a traditional power combiner. These digital drive signals are, e.g., synthesised using a Field Programmable Gate Array (FPGA) which allows for the generation of many of those signals in parallel that have in addition a digitally adjustable phase relation between them. The transmission of the digital signals from the FPGA to the PAMs can be done galvanically coupled or using an optical link.

In a preferred embodiment, PAMs are based on solid state transistor technology, e.g. LDMOS, GaN or any other semiconductor transistor technology suitable for amplifying RF/MW signals to the required output power level. The transistor can be implemented into the PAM in either a proportional topology (e.g. amplifier classes A to C) or as switched mode topology (e.g. classes D,E and above). In a preferred embodiment, the switch mode topology using a gate driver circuit as in **Figure 3** is chosen as it allows to create a PAM with highest gain and efficiency but also lowest cost compared to a proportional topology.

Current prior art RF/MW power amplifiers with multiple amplifying elements (usually a transistor) work as following: An RF/MW signal is created by, e.g., an oscillator, amplified by a preamplifier, then split and fed into the number of PAMs needed to reach the desired output power.

In some implementations, the preamplifier is integrated into the PAM, leading to a lower power requirement of the drive signal. In case the PAM design is a switch mode amplifier (e.g., class E, F, its inverse modes or mixtures of those), the drive signal can be reduced to a low power digital signal (e.g., TTL square wave, 50% duty cycle) when using a gate driver circuit. Low power means that the signal power is in the range of 1mW or lower.

**Figure 4** shows the above-mentioned prior art RF/MW power amplifier with multiple amplifying elements architecture according to prior art: parallel switched mode (without gate driver circuit) or proportional topology with analogue input PAMs **105-1** to **105-N** output their RF/MW power into a power combiner **107** via conductors **106-1** to **106-N,** which may for example be any one of coaxial cables, waveguides or striplines. A combined output power is then delivered from the power combiner **107** to an application via a port **108**, which may be any one of a coaxial or waveguide port.

In the prior art implementation, a drive signal for each PAM **105-1** to **105-N** may be created by a preamplifier **102** that creates a global drive signal derived from a signal source **101** that is split into N drive signals by means of a power splitter **103** and is then fed to the PAMs via coaxial lines **104-1** to **104-N.**

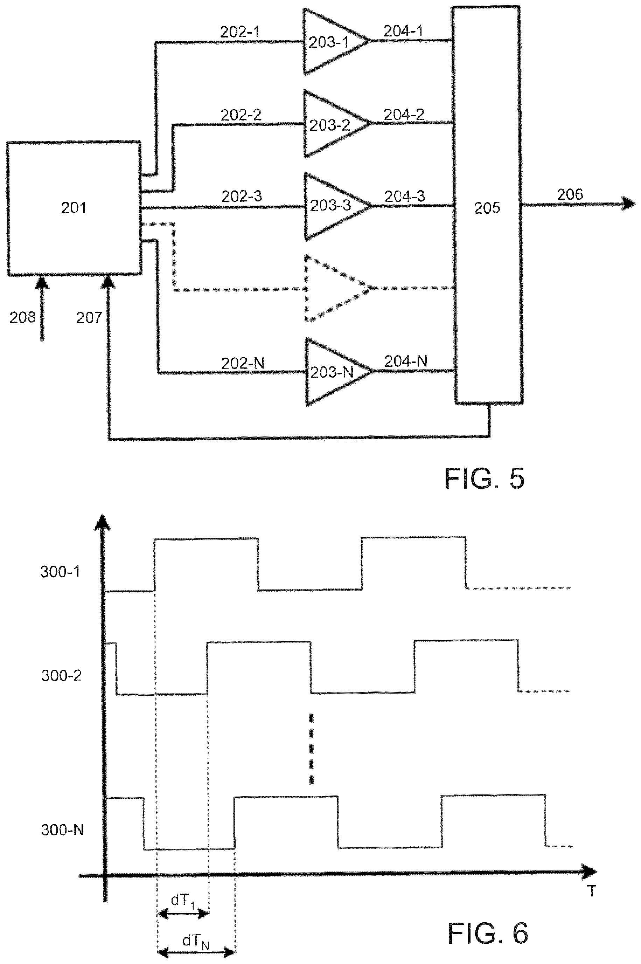

Turning now to **Figure 5**, this shows a RF/MW power amplifier with multiple amplifying elements architecture according to an example embodiment of the invention, which has a few common features with the power amplifier of **Figure 4**, except that in the scope of the present invention, the preamplifier and power splitter are replaced by a generating system **201** generating low power digital signals to drive switched mode with digital signal input PAMs **203-1** to **203-N** and a galvanically isolated link **202-1** to **202-N** between the generation of the drive signal and the power amplifier module. Accordingly, the PAMs **203-1** to **203-N** are digitally driven.

The galvanically isolated link **202-1** to **202-N** may for example be a transformer with sufficient bandwidth and insulation voltage or, preferably, an optical link. The optical link is configured to have a sufficient RF bandwidth, which as a minimum exceeds a working frequency and preferably goes to multiple times the working frequency. In a preferred embodiment, the optical link is formed by an optocoupler. Another preferred implementation may be a configuration in which the transport of the optical signal is done via an optical fibre, allowing for more flexible distribution of the signal within a device or enclosure. By selecting lengths of the fibres, fixed phase offsets may be realised to the different switched mode with digital signal input PAMs.

In **Figure 5**, the N digital signals are created by the means of a digital control circuit **201**, e.g., an implementation in an FPGA. All N signals should but must not have the same frequency and duty cycle and are derived from a reference frequency **208**. Each of N outputs of the digital control circuit **201** may be adjusted in phase relative to each other to compensate for manufacturing and component tolerances of the switched mode with digital signal input PAMs **203-1** to **203-N** and power combiner **205** that would lead to losses and reflection. On the PAM's side, the digital signal is fed to a gate driver IC (not represented in **Figure 5**) that is part of a typical switched mode amplifier topology. A combined output power is then delivered from the power combiner **205** to an application via a port **206**, which may be any one of a coaxial or waveguide port.

**Figure 6** shows an example implementation of the digital drive signals that can be used to drive multiple PAMs in the above-described topology. **300-1** to **300-N** refer to generalised square wave waveforms with time T on a horizontal axis and amplitude in arbitrary units in a vertical axis. The square wave waveforms **300-1** to **300-N** can but must not have a 50% duty cycle. The square wave waveforms in this example have a phase shift of dT₁ from waveform **300-1** to waveform **300-2** and dT_{N} from waveform **300-1** to waveform **300-N.**

In the case of an ideal configuration of the power combiner **205**, the phase shifts dT, to dT_{N} are zero. Due to production tolerances, temperature related component value shifts, the non-zero size of the circuit and potentially design choices, the ideal input phases of the power combiner are not identical. In this case, relative phase shifts of the waveform signals **300-1** to **300-N** may be adjusted individually in the digital control circuit **201.**

The amount of phase shift applied to each output may be determined by initial measurement of the power combiner before installation, e.g., using a vector network analyser or in-situ by measuring the phase imbalance between the inputs in the power combiner **205.** An in-situ measurement allows for feedback **207** to the signal generator and therefore an active compensation of the phase shifts arising from component values shifts due to temperature or ageing.

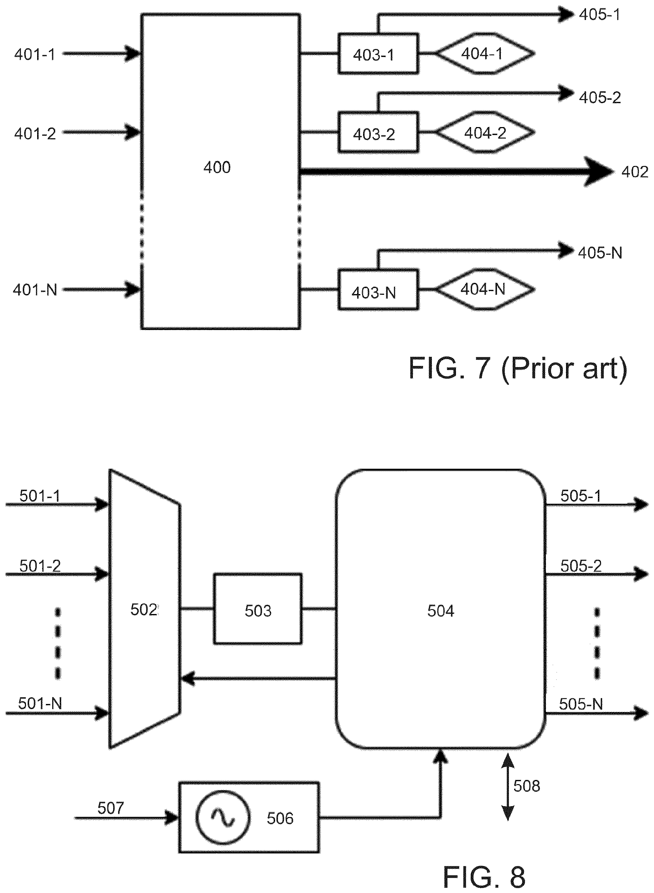

RF or MW power combiner are passive circuits that are used to combine the output power of multiple RF or MW sources into a single output. Most RF or MW power combiners have a resistive element used as termination for the losses occurring in case of phase or amplitude imbalance between inputs. **Figure 7** shows an overview of a power combiner **400**, according to an example of prior art, in this case of the Gysel topology. It will also apply to other topologies that use terminations to dissipate power that cannot be combined into the output due to phase or amplitude imbalances (e.g., Wilkinson or 3dB hybrid types).

In power dividers such as the power combiner **400**, terminations **404-1** to **404-N** are integral parts of the power combiner **400** but are shown separately to the residual part of the power combiner **400** for illustration purposes.

Input power from the PAMs (PAMs not represented in **Figure 7**) is supplied by input ports **401-1** to **401-N**, in case of a perfect power combiner **400** and fully coherent power delivery by the **N** sources, a combined power will be available at an output port **402.**

In case of incoherence between any of the input ports **401-1** to **401-N**, parts of the input power are not combined into the output port **402** but are deviated into the terminations **404-1** to **404-N.**

E.g., assuming a Gysel combiner with two power inputs (also called ports) powered by two signals with the same amplitude but with a phase difference:
*Case 1:* Both input signals are in phase, the power to the termination resistors is 0.
*Case 2:* The phase of the signal on port 2 is advanced compared to the phase of the signal on port 1. Termination 1 sees a signal in advance relative to input phase 1, the phase advance and amplitude increases with phase difference. Termination 2 sees the same as termination 1 but with 180° phase shift.
*Case 3:* The phase of the signal on port two lags compared to the phase of the signal on port 1. Termination 1 sees a signal lagging relative to input phase 1, the lag and amplitude increases with phase difference. Termination 2 sees the same as termination 1 but with 180° phase shift.

Similar behavioural models can be extracted for combiner with more than two input ports. The phase difference between the input ports can therefore be extracted by measuring the phase and amplitude of the signal going into the different terminations. To do so, a directional coupler or RF/MW tap **403-1** to **403-N** is inserted in front of each termination resistor **404-1** to **404-N.** The resulting **N** signals **405-1** to **405-N** are then routed to the digital control circuit **201** (not illustrated in **Figure 7** but known from **Figure 5**) for processing (grouped in link **207** in **Figure 5**).

**Figure 8** shows the digital control circuit **201** in more detail. Signals 501-1 to 501-N (corresponding to **405-1** to **405-N** in **Figure 7**) derived from the power combiner's terminations (not illustrated in **Figure 8**) arrive at an analogue multiplexer **502.** An input channel of the analogue multiplexer **502** is selected by a main control logic **504.** A selected output signal is then transmitted as an incoming signal to an analogue to digital converter (ADC) **503** that samples the incoming signal with sufficient resolution in time and amplitude. A resulting digital sample data is transferred to a main control logic **504.** Alternatively, in a preferred embodiment, the analogue to digital converter **503** may further comprise a phase and frequency detector in addition to the ADC, allowing to decrease the amount of sampling significantly. In this case, a phase reference has to be provided to the analogue to digital converter **503** by either the main control logic **504** or directly by a reference oscillator **506.**

The main control logic **504** compares the sampled signals to the reference oscillator **506.**

The reference oscillator **506** may optionally be locked to an optional external frequency source **507** (corresponding to reference **208** in **Figure 5**).

In a further preferred embodiment, the reference oscillator **506** is an integral part of the main control logic **504**, e.g., in case an FPGA is used with internal phase locked loops (PLL) and oscillators.

The result in digital form is the phase offset of each input port of the power combiner relative to the reference oscillator **506.**

With this data, the main control logic **504** may then adjust output signals **505-1** to **505-N** (corresponding to references **202-1** to **202-N** in **Figure 5** and displayed as waveforms **300-1** to **300-N** in **Figure 6**) according to the following method:
1. The phase of **505-1** is aligned to the reference oscillator **506.**
2. The phase of **505-2** is aligned to the phase of **505-1.**
3. The phase of **501-2** is measured and subtracted from the reference oscillator **506.**
   a. In case of a negative result, the phase of **505-2** is reduced until **501-2** is in phase with the reference oscillator **506** and the signal vanishes in amplitude.
   b. In case of a positive result, the phase of **505-2** is increased until **501-2** is in phase with reference oscillator **506** and the signal vanishes in amplitude.
   c. In case the signals **505-1** and **505-2** are zero in amplitude, the phase stays unchanged.
4. In a repeatable manner and for all channels N, the above feedback is applied to all channels N with respect to the phase of the main oscillator.

This method effectively results in a continuous feedback from the power combiner **205** to the digital control circuit **201** via the link **207.** The power combination will therefore be as efficient as possible, an initial tuning of the PAMs **203-1 to 203-N** and the power combiner **205** (from **Figure 5**) might in the ideal case not be necessary or can be done with relaxed tolerances.

Case of the method step 3.c. herein above is the case for an ideal system, in a real implementation that is subject to imperfections like component tolerances, the main control logic will use minimization algorithms to find the best phase match possible and then continue with the next channel in the same way.

The drive signals **202-1** to **202-N** (that correspond to **505-1** to **505-N**) can be created in different ways. One discrete solution would be to create a signal at working frequency in the local oscillator for the reference oscillator **506** that can but must not be locked to the external frequency source **507.**

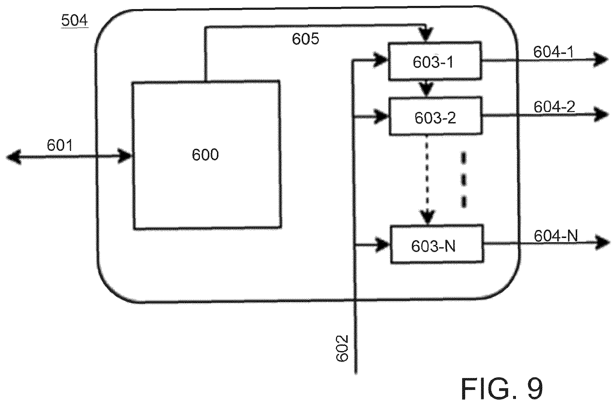

**Figure 9** shows an example embodiment of the main control logic **504.** An internal control logic **600** controls the multiplexer **502** and ADC **503** and receives phase information **601** from the power combiner (not illustrated in **Figure 9** but known from **Figure 8**) in digital form and makes decisions on the phase feedback accordingly. To control the phases of the input signal to the PAMs (not illustrated in **Figure 9**), the internal control logic **600** sets the values of RF/MW phase shifters **603-1** to **603-N** according to the above-mentioned method using a control link **605.** The phase shifters **603-1** to **603-N** receive a reference signal **602** from the reference oscillator **506** (not illustrated in **Figure 9**) and shift the phase by the calculated amount. The shifted signal is output via links **604-1** to **604-N** that correspond to the drive signals **202-1** to **202-N** (not illustrated in **Figure 9**, but shown in **Figure 5**).

In a preferred embodiment, the architecture in **Figure 9** is fully integrated into an FPGA. In a further preferred embodiment, the architecture is built up using discrete components, e.g., a microcontroller and digital or analogue phase shifters. In the FPGA implementation, the phase shift may be implemented by, e.g., using phase locked loops or gate delays for fine tuning.

The described invention can in addition be used to cover the following cases that occur during first testing and also during the service life of the device:
1. Failure in a PAM or in any connection to and from it. This can occur at first testing or during operation due to ageing or other effects. In this case the above-described phase alignment method will not converge, e.g., in case of a system with two ports it will not be possible to reduce the amplitude measured at the two termination resistors to zero. The control logic **504** can capture this case and react by signalling an alarm via the digital communication interface **508** to an interlocking or diagnostics system. To do so, a specific diagnostics program has to run inside the control logic **504** that alternates with the program that instantiates the above-described method. Additionally, the control logic **504** can be programmed to switch off all digital drive signals **505-1** to **505-N** or only the drive signal to the malfunctioning PAM.
2. Self-testing and calibration functionality. After assembly of the system, the control logic **504** can run a testing program that compares the digitised signals **501-1 to 501-N** to known reference signals. By changing the drive signal **505-1 to 505-N** phase and comparing the change with the phase change of the corresponding digitised signal, errors in cabling and manufacturing issues in the combiner can be detected and signalled using the communication interface **508.** This interface can also be used to supply potential reference signals that are measured with external measurement devices, e.g., vector network analysers or vector voltmeters for calibration purposes during production.

## Claims

1. A solid-state power amplifier architecture comprising
a plurality of switched mode with gate driver circuit and digital input power amplifier modules (203-1 to 203-N), and
a digital control circuit (201) configured to drive the plurality of switched mode with digital input power amplifier modules (105-1 to 105-N) with corresponding digital signals,
whereby the digital control circuit is further configured for adjusting the phase of the digital signals relative to each other,
and the solid-state power amplifier architecture further comprises
an RF or MW power combiner (205) with load terminations (404-1 to 404-N) that are equipped each with a corresponding directional coupler (403-1 to 403-N) that is configured to sample the signal into the load terminations, and
a feedback system (207) implemented in the digital control circuit that uses the sample signals to adjust the phase of the digital signals to each other according to a method that maximises the efficiency of the power combination by minimising the signal into the load terminations (404-1 to 404-N) by adjusting the phase of the digital signals (202-1 to 202-N) into the power amplifier modules (203-1 to 203-N) relative to each other.

2. The solid-state power amplifier architecture of claim 1, wherein the digital control circuit is implemented in discrete logic, using any one of a microcontroller or an FPGA.

3. The solid-state power amplifier architecture of claim 1, in which the digital signals are transmitted from the source to the power amplifier modules by means of a galvanically decoupled link.

4. The solid-state power amplifier architecture of claim 3, wherein the galvanic decoupled link comprises optical fibres.

5. The solid-state power amplifier architecture of claim 3, wherein the galvanic decoupled link comprises a transformer.

6. The solid-state power amplifier architecture of claim 1, where the digital signals for the PAMs can be independently changed in phase using the digital control circuit.

7. The solid-state power amplifier architecture wherein the power combiner is an N-channel power combiner that integrates feedback information on an input phase and amplitude alignment and is configured to feed the feedback information to a controller that sets the input phase to the PAMs to achieve best power combination efficiency.

8. The solid-state power amplifier architecture of claim 1 in which the digital control logic is configured to perform self-tests and calibration of the solid-state power amplifier architecture by means of a testing program.

9. The solid-state power amplifier architecture of claim 1 in which the digital control logic is configured to detect failures in the solid-state power amplifier architecture by means of a diagnostics program.

10. The solid-state power amplifier architecture of any one of claims 1 to 9, wherein the digital signal is a low power signal with only two defined states.
